**Europäisches Patentamt**

**European Patent Office**

**Office européen des brevets**

(19)

(11) Veröffentlichungsnummer : **0 500 615 B1**

(12)

# EUROPÄISCHE PATENTSCHRIFT

(45) Veröffentlichungstag der Patentschrift :
**14.09.94 Patentblatt 94/37**

(51) Int. Cl.⁵ : **H01L 21/316**

(21) Anmeldenummer : **90916234.9**

(22) Anmeldetag : **09.11.90**

(86) Internationale Anmeldenummer :
**PCT/DE90/00857**

(87) Internationale Veröffentlichungsnummer :
**WO 91/07774 30.05.91 Gazette 91/12**

(54) **VERFAHREN ZUM HERSTELLEN EINER SILIKATSCHICHT IN EINER INTEGRIERTEN SCHALTUNG.**

(30) Priorität : **13.11.89 DE 3937723**

(43) Veröffentlichungstag der Anmeldung :
**02.09.92 Patentblatt 92/36**

(45) Bekanntmachung des Hinweises auf die
Patenterteilung :
**14.09.94 Patentblatt 94/37**

(84) Benannte Vertragsstaaten :
**DE FR GB IT NL**

(56) Entgegenhaltungen :
**EP-A- 0 283 311**
**DE-A- 3 416 470**
**US-A- 4 781 942**
**THIN SOLID FILMS, vol. 174, no. 1, July 1989,**
**Elsevier Sequoia, (Lausanne, CH) ; W. Kulisch**
**et al. : "Plasma-enhanced chemical vapour**
**deposition of silicon dioxide using tetraet-**
**hoxysilane as silicon source", pages 57-61.**

(73) Patentinhaber :
**FRAUNHOFER-GESELLSCHAFT ZUR**
**FÖRDERUNG DER ANGEWANDTEN**
**FORSCHUNG E.V.**
**Leonrodstrasse 54**
**D-80636 München (DE)**

(72) Erfinder : **SIGMUND, Hermann**
**Wohlhornstrasse 83**
**D-8034 Germering (DE)**
Erfinder : **KLUMPP, Armin**
**Ringseisstrasse 12**
**D-8000 München 2 (DE)**

(74) Vertreter : **Schoppe, Fritz, Dipl.-Ing. et al**
**Patentanwalt,**
**Georg-Kalb-Strasse 9**
**D-82049 Pullach (DE)**

EP 0 500 615 B1

**Beschreibung**

Die vorliegende Erfindung betrifft ein Verfahren zum Herstellen einer Silikatschicht in einer integrierten Schaltung.

Silikatschichten innerhalb von integrierten Schaltungen dienen im allgemeinen als Zwischenoxidisolationsschicht zur elektrischen Isolation der Polysiliziumebene und der Diffusionsgebiete, die unterhalb der Zwischenoxidisolationsschicht liegen, und der oberhalb der Zwischenoxidisolationsschicht angeordneten Leiterbahnen, die beispielsweise aus Aluminium bestehen können. Ferner dient die Zwischenoxidisolationsschicht zum Vergleichmäßigen oder Verrunden von topographischen Unebenheiten der auf dem Substrat bis zur Polysiliziumstrukturierung ausgebildeten Schaltungsstrukturen. Die Höhenstufen der Schaltungsstrukturen müssen durch die Zwischenoxidisolationsschicht verrundet und nach Möglichkeit ausgeglichen werden, da es ansonsten bei der Herstellung der Aluminiumleiterbahnen mittels eines nachfolgenden Aluminium-Sputterprozesses zu Abschattungseffekten kommen kann, und da ferner zu starke Stufen in der Unterlage zu Überhängen und Abrissen der Aluminiumleiterbahnen führen können. Diese Probleme werden mit zunehmender Integrationsdichte der integrierten Schaltung immer kritischer, da aufgrund abnehmender lateraler Abmessungen mit zunehmender Integrationsdichte bei gleichbleibender Schichtdicke der topographischen Stufen das Höhen-Breiten-Verhältnis zunimmt.

Für die somit erforderliche Einebnung von strukturierten Oberflächen von integrierten Schaltungen werden gegenwärtig vor allem zwei Verfahren eingesetzt, die nachfolgend erläutert werden:

Gemäß dem ersten Verfahren wird eine Polysiloxanschicht in einem Schleuderverfahren auf die topologisch unebenen, auf einem Substrat ausgebildeten Schaltungsstrukturen aufgebracht. Die auf diese Weise aufgebrachten Polysiloxanschichten werden auch als Spin-on-Gläser (SOG) bezeichnet. Die Polysiloxanschicht wird nach dem Aufbringen im Schleuderverfahren in einem nachfolgenden Temperprozeß in eine Silikatschicht bzw. $SiO_2$-Schicht umgewandelt. Bei diesem Verfahren kann die chemische Zusammensetzung der Polysiloxanschicht nicht variiert werden und das Fließverhalten bzw. die Viskosität der Polysiloxanschicht sowie deren Schichtdicke nur in engen Grenzen eingestellt werden. Bei dem Aufbringen von Polysiloxanschichten im Schleuderverfahren ist es technologisch sehr schwierig, dünne Schichten und Schichten mit homogener Dicke über große Scheibendurchmesser zu erzeugen. Ferner können die chemische Zusammensetzung und damit die Viskosität und die Fließeigenschaften von kommerziell erhältlichen Polysiloxanen nicht den Anforderungen einer speziellen Topographie der integrierten Schaltung angepaßt werden, wie dies zum Beispiel zum Auffüllen eines Trenches nötig sein kann, da die Anpassung der Zusammensetzung und der Fließeigenschaften der Polysiloxane nur über deren Hersteller erfolgen kann.

Bei dem zweiten bekannten Verfahren werden im chemischen Dampfabscheidungsverfahren aus der Gasphase (CVD) Bor-Phosphor-Silikat-Glas-Schichten als Zwischenisolationschichten erzeugt. Bei diesem Dampfabscheidungsverfahren werden als Ausgangsgase bevorzugt Silanverbindungen oder organische Siloxanverbindungen zusammen mit Dotiergasen, wie beispielsweise $B_2H_6$ bzw. $PH_3$, sowie Sauerstoff ($O_2$) verwendet. Diese Bor-Phosphor-Silikat-Glas-Schichten können mittels einer rein thermischen Reaktion bei Atmosphärendruck oder im Niederdruckbereich wie auch im Plasma abgeschieden werden. Die Bor-Phosphor-Silikat-Glas-Schichten haben hohe Fließtemperaturen und führen somit zu einem hohen Temperaturbudget bei dem Gesamtherstellungsprozeß. Ferner müssen zum Verhindern einer Ausdiffusion von Bor oder Phosphor zusätzliche diffusionshemmende Abdeckschichten, wie beispielsweise Siliziumnitridschichten, verwendet werden, was den Gesamtherstellungsprozeß belastet. Darüberhinaus sind Bor-Phosphor-Silikat-Glas-Schichten aufgrund ihrer komplexen chemischen Struktur und Zusammensetzung bei nachfolgenden Prozeßschritten, wie beispielsweise dem Ätzen von Kontaktlöchern, schwierig zu handhaben.

Aus der Fachveröffentlichung "Solid State Technology, April 1988, Seiten 119 bis 122" ist bereits ein PE-TEOS-Verfahren bekannt, das zum Erzeugen einer dielektrischen Zwischenschicht dient. Bei diesem Verfahren wird $SiO_2$ abgeschieden. Die Produktion der Spezies erfolgt durch Plasmazündung im Gasraum. Die Reaktion der Spezies auf der Waferoberfläche erfolgt bei Temperaturen oberhalb von 300°C. Dies führt zu einer adsorptionskontrollierten Reaktion, aufgrund derer es zu einer konformen Bedeckung der Waferoberfläche kommt.

Aus der GB 2 048 230 ist ein Verfahren zum photochemischen Dampfabscheiden von Oxiden bekannt. Eine Verfahrensvariante des bekannten Verfahrens bedient sich als Ausgangsstoffe einem Sauerstofflieferanten sowie TEOS. Soweit der Entgegenhaltung Details bezüglich der Reaktionsführung zu entnehmen sind, scheint es sich bei der Reaktionsführung des bekannten Verfahrens um eine diffusionslimitierte Abscheidung zu handeln.

Die DE-A-34 16 470 zeigt ein sogenanntes Trockenverfahren, unter dem ein Ätzverfahren für das gleichmäßige Ätzen von Halbleiterstrukturen oder eine CVD-Abscheidung von amorphem Silizium verstanden wird. Für den Fall der Abscheidung von amorphem Silizium wird eine Vorrichtung mit getrennten Kammern vorgesehen, zwischen denen eine Ausströmdusche liegt, um eine Druckdifferenz zu erzeugen, wobei eine Polymerisation mittels Lichtanregung durch eine externe Lichtquelle herbeigeführt wird. Bei dem Verfahren nach dieser Schrift geht es weder um die Optimierung des Ausgleichs topographischer Unebenheiten mittels einer Zwischenoxidisolationsschicht noch um einen solchen Reaktionsverlauf, der in einem räumlichen Bereich vollständig abgeschlossen wird, noch um eine solche Wahl der Temperatur- und Druckverhältnisse, daß innerhalb der unteren Kammer der Vorrichtung eine Kondensation der gebildeten Produkte auftritt.

Aus der EP-A-28 33 11 ist ein Dünnfilmerzeugungsverfahren bekannt, bei dem zum Auffüllen von Trenches durch ausreichend niedrige Einstellung der Substrattemperatur eine Ablagerung des Ausgangsmateriales auf dem Substrat in der Flüssigphase stattfindet. Diese Schrift lehrt den Fachmann, von dem in der Beschreibungseinleitung dieser Schrift gewürdigten TEOS-Verfahren keinen Gebrauch zu machen, da dies in dieser Schrift als zum Ausgleich topographischer Unebenheiten untauglich abgetan wird, und anstelle dessen unmittelbar eine Ausgangssubstanz als Flüssigkeitsfilm abzuscheiden, wobei innerhalb des Prozesses nach dieser Schrift die Beiträge der Gasphasenreaktion von untergeordneter Bedeutung sind.

Ausgehend von diesem Stand der Technik liegt der vorliegenden Erfindung die Aufgabe zugrunde, ein Verfahren zum Herstellen von Silikatschichten so weiterzubilden, daß die erzeugte Silikatschicht topographische Unebenheiten weitgehend ausgleicht, über große Flächen mit gleichmäßig bestimmbarer Schichtdicke herstellbar ist und daß das Fließverhalten der abgeschiedenen Polysiloxanschicht frei einstellbar ist.

Diese Aufgabe wird durch ein Verfahren gemäß Patentanspruch 1 gelöst.

Ein bevorzugtes, beispielhaftes Verfahren sowie eine Ausführungsform einer Vorrichtung zum Durchführen des Verfahrens werden nachfolgend unter Bezugnahme auf die beiliegenden Zeichnungen näher erläutert. Es zeigen:

Fig. 1 ein Ausführungsbeispiel einer Vorrichtung zum Herstellen einer Silikatschicht, die zum Durchführen des erfindungsgemäßen Verfahrens geeignet ist; und

Fig. 2 eine Schnittdarstellung durch eine integrierte Schaltung mit einer flachen Grabenstruktur nach Aufbringen einer Silikatschicht mittels des erfindungsgemäßen Verfahrens in der erfindungsgemäßen Vorrichtung.

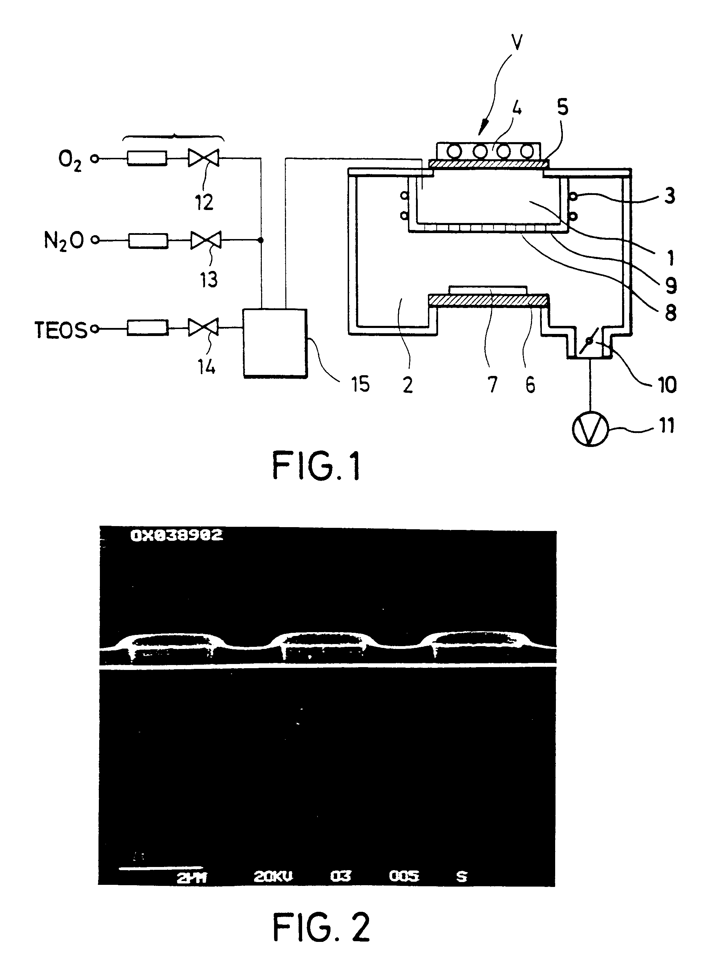

Die in Fig. 1 gezeigte Vorrichtung zum Herstellen einer Silikatschicht als Zwischenoxidisolationsschicht in einer integrierten Schaltung zum Ausgleichen topographischer Unebenheiten von auf einem Substrat der integrierten Schaltung ausgebildeten Schaltungsstrukturen ist in ihrer Gesamtheit mit dem Bezugszeichen V bezeichnet und umfaßt einen Reaktionsraum 1 sowie einen Kondensationsraum 2. Der Reaktionsraum 1 ist mittels einer als Heizschlange 3 ausgeführten Heizvorrichtung beheizbar und mit einer Lichtquelle für ultraviolettes Licht bestrahlbar, die von dem Reaktionsraum 1 durch eine Glasplatte 5 getrennt ist. Im Kondensationsraum 2 ist eine elektrisch beheizbare Aufnahmevorrichtung 6 für eine zu beschichtende Halbleiterscheibe, die im Beispielsfall eine Siliziumscheibe 7 ist.

Zwischen dem Reaktionsraum 1 und dem Kondensationsraum 2 liegt eine Ausströmdusche 8, deren Durchströmungsöffnungen 9 mit einem derartigen Querschnitt ausgebildet sind, daß sich vom Reaktionsraum 1 zum Kondensationsraum 2 eine Druckdifferenz über die Ausströmdusche 8 in der Größenordnung von 100 mbar aufbaut.

Der Kondensationsraum 2 ist über ein Regelventil 10 an eine Pumpe 11 angeschlossen, mit dem der Kondensationsraum auf ein Druckniveau evakuierbar ist, das mittels des Regelventiles 10 einstellbar ist.

Ein $O_2$-haltiges Gas ist zu dem Reaktionsraum 1 über ein erstes Flußregelventil 12 zuführbar. Ein $N_2O$-haltiges Gas ist zu dem Reaktionsraum 1 über ein zweites Flußregelventil 13 zuführbar. Eine SiO-haltige organische Verbindung, die vorzugsweise Tetraethylorthosilikat ist, ist zu dem Reaktionsraum über ein drittes Flußregelventil 14 zuführbar. Zwischen den Flußregelventilen 12, 13, 14 und dem Reaktionsraum 1 liegt ein Verdampfer 15 zum Verdampfen des im flüssigen Zustand zugeführten Tetraethylorthosilikates.

Die Flußregelventile 12, 13, 14 werden derart eingestellt, daß das Mischungsverhältnis der zugeführten Gase beispielsweise Tetraethylorthosilikat : $O_2$ : $N_2O$ dem Verhältnis 3 : 10 : 10 unter der Voraussetzung von Normalbedingungen (1 bar, 300 K) entspricht.

Durch entsprechende Einstellung der Heizleistung der Heizschlange 3 wird die Reaktionstemperatur auf 120° bis 150°C in einem Druckbereich von vorzugsweise 100 bis 800 mbar Reaktionsdruck eingestellt.

Durch entsprechende Einstellung der Heizleistung der Aufnahmevorrichtung 6 wird die Kondensationstemperatur, die der Temperatur der Siliziumscheibe 7 entspricht, auf einen Bereich zwischen 30° und 90°C eingestellt. Der Druck im Kondensationsraum liegt vorzugsweise weniger als 100mbar unterhalb der Druck im Reaktionsraum.

Anschließend wird die Polysiloxanschicht entweder in einem rein thermischen Temperprozeß oder in einem photounterstützten Temperprozeß in eine Silikatschicht umgewandelt. Im Anschluß hieran kann auf die so erzeugte Silikatschicht in an sich bekannter Weise eine Struktur aus Aluminiumleiterbahnen aufgebracht werden.

Bei dem oben beschriebenen Verfahren wird Tetraethylorthosilikat als Precursor eingesetzt. Anstelle von SiO-haltigen organischen Verbindungen als Precursor können auch SiC-haltige organische Verbindungen eingesetzt werden.

Die Summenformel der Polysiloxane für die beiden genannten Fälle lautet folgendermaßen:

$$(1) \quad Si\ [O_{2x}\ (OH)_{4y}\ (OC_2H_5)_{4z}] \qquad x + y + z = 1$$
$$x,\ y,\ z\ \neq\ 0$$

$$(2) \quad Si\ [O_{2x}\ (OH)_{4y}\ (CH_3)_{4z}] \qquad x + y + z = 1$$
$$x,\ y,\ z\ \neq\ 0$$

Formel (1) gilt für den Fall, daß TEOS $Si(OC_2H_5)_4$ als Precursor verwendet wird,

Formel (2) für den Fall, daß Precursoren verwendet werden, welche Si - C Bindungen enthalten, wie z.B. Hexamethyldisiloxan oder Tetramethylcyclotetrasiloxan.

Als SiO-haltige oder SiC-haltige organische Verbindung bzw. als Precursor kommen folgende Substanzen in Betracht:

I. Alkylsilane, z.B. Tetramethylsilan $Si(CH_3)_4$;

II. Alkoxysilane, z.B. Tetraethoxysilan (TEOS) $Si(OC_2H_5)_4$;

III. niedermolekulare Siloxane, z.B. Hexamethyldisiloxan $Si_zO(CH_3)_6$; und

IV. niedermolekulare Cyclosiloxane, z.B. Oktamethylcyclotetrasiloxan $Si_4O_4(CH_3)_8$.

Entscheidend für das erfindungsgemäße Verfahren ist es, daß das Polysiloxan durch geeignete Wahl der Temperatur und Druckverhältnisse im Kondensationsraum kondensiert, wobei jedoch eine Kondensation des Precursors im Kondensationsraum auf der Siliziumscheibe 7 verhindert werden soll. Daher wird die Temperatur der Siliziumscheibe 7 so gewählt, daß der Precursor bei dem gegebenen Druck im Kondensationsraum geradeeben nicht mehr kondensiert, wobei jedoch die Temperatur der Siliziumscheibe auf einen solchen Wert begrenzt wird, der eine Kondensation des Polysiloxans bei dem zweiten Druck im Kondensationsraum ermöglicht.

Die erste Temperatur im Reaktionsraum hängt von dem gewählten Precursor ab und muß in Abhängigkeit von dem gewählten Precursor durch Experimente ermittelt werden. Für den bevorzugten Precursor Tetraethylorthosilikat liegen bevorzugte Reaktionstemperaturen zwischen 120° und 150°C.

Im Gegensatz zu der im Stand der Technik üblichen adsorptionskontrollierten Reaktion führt die Kondensation des Polysiloxan auf der Siliziumscheibenoberfläche zu einer bevorzugten Füllung von Strukturen mit negativem Krümmungsradius. Dies führt zu einer verstärkten Planarisierung der Oberfläche.

Das erfindungsgemäße Verfahren ermöglicht eine Produktion des Polysiloxans unmittelbar vor der Verwendung, wobei über die Wahl des Precursors die Eigenschaften des Polysiloxans auf den Anwendungsfall abgestimmt werden können. Die Produktion von Polysiloxan kann durch Bestimmung der Bedingungen der Gasphasenreaktion in dem abgetrennten Reaktionsraum optimiert werden, ohne daß hierbei die erforderlichen Randbedingungen für den Kondensationsprozeß im Kondensationsraum in Betracht gezogen werden müssen. Nach der Kondensation von Polysiloxan auf der Halbleiteroberfläche in einer Flüssigphase findet keine Reaktion auf der Oberfläche mehr statt. Diese Art der Verfahrensführung steht im Gegensatz zu der Verfahrensführung bei den bekannten Verfahren, wie sie eingangs erläutert wurden.

Fig. 2 zeigt eine Schnittdarstellung durch eine Siliziumscheibe 7 mit einer flachen Grabenstruktur oder Trenchstruktur, die mittels des erfindungsgemäßen Verfahrens mit einer Silikatschicht beschichtet ist, welche die topologischen Stufen weitgehend ausgleicht.

Bei den beschriebenen Verfahren wird die Silikatschicht zum Ausgleichen topographischer Unebenheiten von auf einem Substrat einer integrierten Schaltung ausgebildeten Schaltungsstrukturen verwendet. Die mittels des erfindungsgemäßen Verfahrens erzeugten Silikatschichten sind jedoch nicht auf diesen Anwendungsfall beschränkt, sondern können allgemein als Dielektrikum in jeder Anwendungsart eingesetzt werden.

**Patentansprüche**

1. Verfahren zum Herstellen einer Silikatschicht als Zwischenoxidisolationsschicht in einer integrierten Schaltung zum Ausgleichen topographischer Unebenheiten von auf einem Substrat der integrierten Schaltung ausgebildeten Schaltungsstrukturen,

mit folgenden Verfahrensschritten:

- photoinduzierte Herstellung von Polysiloxan mittels Gasphasenreaktion ausgehend von einer SiO-haltigen oder SiC-haltigen organischen Verbindung zusammen mit einer $O_2$-Atmosphäre und/oder einer $N_2O$-Atmosphäre bei einer ersten Temperatur und einem ersten Druck in einem Reaktionsraum;

- Kondensieren von Polysiloxan zum Erzeugen einer Polysiloxanschicht auf den Schaltungsstrukturen der auf dem Substrat ausgebildeten integrierten Schaltung, in einem von dem Reaktionsraum getrennten Kondensationsraum,

-- wobei in dem Kondensationsraum ein vorgegebener zweiter Druck herrscht, der unterhalb des ersten Druckes liegt,

-- wobei das Substrat auf eine zweite Temperatur eingestellt wird, die unterhalb der ersten Temperatur liegt und so gewählt ist, daß die SiO-haltige oder SiC-haltige organische Verbindung bei dem zweiten Druck im Kondensationsraum nicht mehr kondensiert, jedoch eine Kondensation des Polysiloxans auf den Schaltungsstrukturen der auf dem Substrat ausgebildeten integrierten Schaltung erfolgt;

und

- Tempern der Polysiloxanschicht, um diese in die Silikatschicht umzuwandeln.

2. Verfahren nach Anspruch 1, dadurch gekennzeichnet,
daß die erste Temperatur zwischen 120° C und 150° C beträgt.

3. Verfahren nach Anspruch 1 oder 2, dadurch gekennzeichnet,
daß die zweite Temperatur zwischen 30° C und 90° C beträgt.

4. Verfahren nach einem der Ansprüche 1 bis 3, dadurch gekennzeichnet,
daß der erste Druck zwischen 100 mbar und 800 mbar beträgt, und
daß der zweite Druck weniger als 100 mbar unterhalb des ersten Druckes liegt.

5. Verfahren nach einem der Ansprüche 1 bis 4, dadurch gekennzeichnet,
daß der Verfahrensschritt der photoinduzierten Herstellung von Polysiloxan das Zuführen der Ausgangsstoffe über voneinander getrennte Flußregler (12 bis 14) und das Verdampfen der SiO-haltigen organischen Verbindung umfaßt.

6. Verfahren nach einem der Ansprüche 1 bis 5, dadurch gekennzeichnet,
daß die SiO-haltige organische Verbindung Tetraethylorthosilikat ($Si(OC_2H_5)_4$) ist.

7. Verfahren nach einem der Ansprüche 1 bis 6, dadurch gekennzeichnet,
daß die Polysiloxanschicht in einem rein thermischen Temperprozeß in die Silikatschicht umgewandelt wird.

8. Verfahren nach einem der Ansprüche 1 bis 6, dadurch gekennzeichnet,
daß die Polysiloxanschicht in einem photounterstützten Temperprozeß in die Silikatschicht umgewandelt wird.

## Claims

1. A method of producing a silicate layer as an intermediate oxide insulation layer in an integrated circuit for levelling topographic irregularities of circuit structures formed on a substrate of said integrated circuit, comprising the following method steps:

- photo-induced producing of polysiloxane by means of vapour-phase reaction taking as a basis an SiO-containing or an SiC-containing organic compound together with an O2-atmosphere and/or an N2O-atmosphere at a first temperature and under a first pressure in a reaction chamber;

- condensing polysiloxane so as to produce a polysiloxane layer on the circuit structures of the integrated circuit formed on the substrate, in a condensation chamber separated from said reaction chamber,

-- the pressure prevailing in said condensation chamber being a predetermined second pressure which is lower than said first pressure,

-- said substrate being adjusted to a second temperature, which is lower than said first temperature and which is chosen such that the SiO-containing or SiC-containing organic compound will no longer condense under said second pressure in the condensation chamber, but that condensation of the polysiloxane on the circuit structures of the integrated circuit formed on said substrate will take place; and

- tempering said polysiloxane layer so as to convert it into the silicate layer.

2. A method according claim 1, characterized in that
the first temperature lies in the range between 120°C and 150°C.

3. A method according to claim 1 or 2, characterized in that
the second temperature lies in the range between 30°C and 90°C.

4. A method according to one of the claims 1 to 3, characterized in that
the first pressure lies between 100 mbar and 800 mbar, and
that the second pressure is less than 100 mbar lower than said first pressure.

5. A method according to one of the claims 1 to 4, characterized in that
the method step of photo-induced producing of polysiloxane comprises the step of supplying the starting materials via separate flow control means (12 to 14) as well as the step of vaporizing the SiO-containing organic compound.

6. A method according to one of the claims 1 to 5, characterized in that
the SiO-containing organic compound is tetraethyl orthosilicate (Si(OC2H5)4).

7. A method according to one of the claims 1 to 6, characterized in that
the polysiloxane layer is converted into the silicate layer in a purely thermal tempering process.

8. A method according to one of the claims 1 to 6, characterized in that
the polysiloxane layer is converted into the silicate layer in a photo-aided tempering process.


**Revendications**

1. Procédé pour la production d'une couche de silicate comme couche d'isolation d'oxyde intermédiaire dans un circuit intégré, destinée à égaliser des irrégularités topographiques de structures de circuit formées sur un substrat du circuit intégré, avec les étapes de procédé suivantes:
   - production par photo-induction de polysiloxane à l'aide d'une réaction en phase gazeuse, partant d'une liaison organique à teneur en SiO ou à teneur en SiC ensemble avec une atmosphère d'O$_2$ et/ou une atmosphère de N$_2$O, à une première température et à une première pression dans une chambre de réaction,
   - condensation de polysiloxane pour produire une couche de polysiloxane sur les sructures de circuit du circuit intégré réalisé sur le substrat, dans une chambre de condensation séparée de la chambre de réaction,
      - dans la chambre de condensation régnant une seconde pression prédéterminée qui est inférieure à la première pression,
      - le substrat étant réglé à une seconde température qui est inférieure à la première température et est choisie de telle manière que la liaison organique à teneur en SiO ou à teneur en SiC ne se condense plus à la seconde pression dans la chambre de condensation, mais qu'il se produit toutefois une condensation du polysiloxane sur les structures de circuit du circuit intégré réalisé sur le substrat,
      et
   - trempe de la couche de polysiloxane pour transformer celle-ci en couche de silicate.

2. Procédé suivant la revendication 1, caractérisé en ce que la première température se situe entre 120°C et 150°C.

3. Procédé suivant la revendication 1 ou 2, caractérisé en ce que la seconde température se situe entre 30°C et 90°C.

4. Procédé suivant l'une des revendications 1 à 3, caractérisé en ce que la première pression se situe entre 100 mbars et 800 mbars, et que la seconde pression se situe à moins de 100 mbars au-dessous de la première pression.

5. Procédé suivant l'une des revendications 1 à 4, caractérisé en ce que l'étape de procédé de la production par photo-induction de polysiloxane comporte l'alimentation des matières de départ par des régulateurs de flux (12 à 14) séparés l'un de l'autre et l'évaporation de la liaison organique à teneur en SiO.

6. Procédé suivant l'une des revendications 1 à 5, caractérisé en ce que la liaison organique à teneur en SiO est de l'orthosilicate de tétra-éthyle $(Si(OC_2H_5)_4)$.

7. Procédé suivant l'une des revendications 1 à 6, caractérisé en ce que la couche de polysiloxane est transformée en couche de silicate par un procédé de trempe purement thermique.

8. Procédé suivant l'une des revendications 1 à 6, caractérisé en ce que la couche de polysiloxane est transformée en couche de silicate par un procédé de trempe assisté par de la lumière.

FIG.1

FIG. 2